# EUROPEAN PATENT APPLICATION

(11) **EP 2 977 701 A1**
(43) Date of publication of application: **27.01.2016**
(21) Application number: 15176906.4
(22) Date of filing: 15.07.2015
(51) Int. Cl.: F28F 3/02, F28F 3/12, F28D 1/03, H01L 23/46, F28F 21/08

(54) **HEAT TRANSFER PLATE**

(30) Priority: 22.07.2014 US 201414337478
(71) Applicant: Hamilton Sundstrand Space Systems International, Inc., Windsor Locks, CT 06096 (US)
(72) Inventor: STRANGE, Jeremy M., Windsor, CT Connecticut 06095 (US); DIEP, Chuong H., Enfield, CT Connecticut 06082 (US); BANACH, Thomas E., Barkhamsted, CT Connecticut 06063 (US); SCULL, Timothy D., Riverton, CT Connecticut 06065 (US)
(74) Representative: Hall, Matthew Benjamin

(57) **Abstract**

A heat transfer device includes a body (101) defining a fluid inlet (103) and a fluid outlet (105), a fluid channel (107) defined within the body, the fluid channel connected in fluid communication between the fluid inlet and the fluid outlet, and a plurality of pins (109) disposed within the fluid channel such that flow passing through the fluid channel passes around the plurality of pins to facilitate heat transfer to the fluid from the body.

## Description

### BACKGROUND

### 1. Field

The present disclosure relates to heat transfer systems, more specifically to heat transferring structures and plates.

### 2. Description of Related Art

Electrical components in circuitry (e.g., aircraft or spacecraft circuits) include heat generating components and require sufficient heat transfer away from the heat generating components in order to function properly. Many mechanisms have been used to accomplish cooling, e.g., fans, heat transfer plates, and actively cooled devices such as tubes or plates including tubes therein for passing coolant adjacent a hot surface. While circuitry continues to shrink in size, developing heat transfer devices sufficient to move heat away from the components is becoming increasingly difficult.

Such conventional methods and systems have generally been considered satisfactory for their intended purpose. However, there is still a need in the art for improved heat transfer devices. Recent advancements in metal based additive manufacturing techniques allow the creation of micro-scale, geometrically complex devices not previously possible with conventional machining. The use of conductive metal and innovative geometries offers many benefits to devices cooling high heat flux energy sources. The present disclosure provides a solution for this need.

### SUMMARY

In at least one aspect of this disclosure, a heat transfer device includes a body defining a fluid inlet and a fluid outlet, a fluid channel defined within the body, the fluid channel connected in fluid communication between the fluid inlet and the fluid outlet, and a plurality of pins disposed within the fluid channel such that flow passing through the fluid channel passes around the plurality of pins to facilitate heat transfer to the fluid from the body.

The body can include two plates such that the pins are disposed across the channel between the two plates to facilitate heat transfer between the plates and the flow passing through the fluid channel. The body can be configured to mount to an electrical component. In certain embodiments, the body can include aluminum or any other suitable thermally conductive material.

The body can be about 0.08 inches (about 2 mm) thick or any other suitable thickness. The body can define a plurality of fluid channels as described herein connected in series. The body can define an inlet-outlet plenum fluidly connecting between sequential channels.

The pins can be about 0.04 inches (about 1 mm) in diameter or any other suitable size. The pins can be disposed in a predetermined pattern such that the pins are uniformly spaced within the fluid channel. The pin diameter and wall-to-wall spacing can be tailored throughout the device to meet heat transfer and pressure drop targets. Typical pin to pin spacing can vary from about 0.04 inches (about 1 mm) to about 0.06 inches (about 1.5 mm) or any other suitable sizes. The fluid channel can be designed to follow a sigmoid path. The plurality of pins can include at least one pin of a first diameter and at least one pin of a second diameter different from the first diameter.

A method includes forming a heat transfer device by forming a body having a fluid channel defined within the body, the fluid channel fluidly connecting between a fluid inlet and a fluid outlet. The method also includes forming a plurality of pins disposed within the fluid channel such that flow passing through the fluid channel passes around the plurality of pins to facilitate heat transfer to the fluid from the body. This can include forming the body by additive manufacturing.

These and other features of the systems and methods of the subject disclosure will become more readily apparent to those skilled in the art from the following detailed description taken in conjunction with the drawings.

### BRIEF DESCRIPTION OF THE DRAWINGS

So that those skilled in the art to which the subject disclosure appertains will readily understand how to make and use the devices and methods of the subject disclosure without undue experimentation, exemplary embodiments thereof will be described in detail herein below by way of example only and with reference to certain figures, wherein:
Fig. 1 is a plan view of an exemplary embodiment of a heat transfer device in accordance with this disclosure, schematically showing fluid flow represented by flow arrows;
Fig. 2 is a schematic perspective view of a fluid volume inside a portion the heat transfer device of Fig. 1;
Fig. 3 is a cross-sectional side elevation view of the heat transfer device of Fig. 1, showing the cross-section taken through line 3-3; and
Fig. 4 is a cross-sectional plan view of a portion of the illustration of the heat transfer device of Fig. 1, showing pins disposed therein.

### DETAILED DESCRIPTION

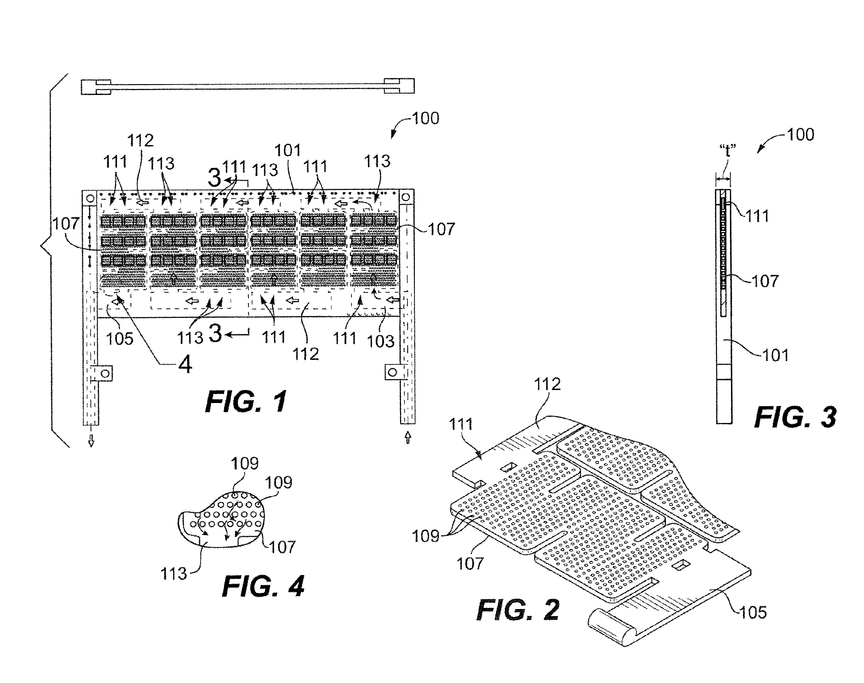

Reference will now be made to the drawings wherein like reference numerals identify similar structural features or aspects of the subject disclosure. For purposes of explanation and illustration, and not limitation, an illustrative view of an exemplary embodiment of a heat transfer device in accordance with the disclosure is shown in Fig. 1 and is designated generally by reference character 100. Other views and aspects of the exemplary heat transfer device 100 are shown in Figs. 2-4. The systems and methods described herein can be used to transfer heat from a heat source (e.g., an electrical component) to a cooling fluid passing through the heat transfer device 100, thereby cooling the heat source.

Referring generally to Fig. 1, a heat transfer device 100 includes a body 101 defining fluid inlet 103 and fluid outlet 105. The body 101 also defines one or more channels 107 defined within the body 101 in fluid communication between the fluid inlet 103 and the fluid outlet 105. It is possible to have a each channel 107 fluidly communicating from inlet 103 to outlet 105, but in embodiments with a plurality of channels 107 as in Fig. 1, the channels 107 can be in fluid communication with one another in series between the fluid inlet 103 and the fluid outlet 105 via a plurality of inlet-outlet plenum 112 connected to channel inlets 111 and channel outlets 113.

Referring to Fig. 2, which shows a fluid volume within the channels 107 (e.g., the inverse of the fluid channels 107), the channels 107 can define a sigmoid shape with a plurality of pins 109 disposed therein. Any other suitable fluid channel 107 design or shape is contemplated herein.

Referring to Fig. 3, the device 100 can be configured to mount to an electrical component (e.g., a microchip or other suitable device) to transfer heat therefrom and to cool the electrical component. Any other suitable heat transfer application using device 100 is also contemplated herein. The body 101 can have a thickness "t" between about 0.05 inches (about 1.25 mm) to about 0.5 inches (about 12.5 mm). In some embodiments, the body 101 can be about 0.08 inches (about 2 mm) thick. The body 101 can have any other suitable thickness and/or cross-sectional design. For example, the body 101 can include a variable thickness to conform to a given design envelope.

Referring to Fig. 1, as shown, fluid can enter into the inlet 103, enter a channel 107 through channel inlet 111, pass through the channel 107 and exit through the channel outlet 113 into an inlet-outlet plenum 112 to pass to the next channel 107. At the last channel 107, the fluid can exit the channel 107 through the channel outlet 113 and into the outlet 105.

Alternatively to the design shown, in some embodiments, the body 101 can define at least one channel inlet 111 for each channel 107 that connect directly to the fluid inlet 103. The channel inlets 111 can include any suitable size and/or shape, and can differ from one another in any suitable manner. The body 101 can also define at least one channel fluid outlet 113 for each channel 107 that connect directly to the fluid outlet 105. The channel fluid outlets 113 can include any suitable size and/or shape, and can differ from one another in any suitable manner. Any other suitable configuration of channel inlets 111 and channel outlets 113 are contemplated herein, as long as the cooling fluid passes through the channels 107.

Referring to Fig. 4, as disclosed above, a plurality of pins 109 can be disposed within the fluid channel 107 such that flow passing through the fluid channel passes around the plurality of pins 109 to facilitate heat transfer to the fluid from the body 101. The pins can be about 0.01 inches (about 0.25 mm) to about 0.5 inches (about 12.5 mm) in diameter. In some embodiments, the pins 109 are about 0.04 inches (about 1 mm) in diameter. The pins 109 can be of any suitable shape (e.g., cylindrical, rectangular), any other suitable dimension, and can be randomized in size and dimension. The pins 109 can be spaced apart in a density of about 450 pins per square inch or any other suitable pin density.

The pins 109 can be disposed in a predetermined pattern such that the pins are uniformly spaced within the fluid channel. For example, the pins 109 can be evenly spaced in rows and columns within the fluid channel 107, or can be disposed unevenly in any suitable pattern. In some embodiments the plurality of pins 109 can include at least one pin 109 of a first diameter and at least one pin 109 of a second diameter different from the first diameter, i.e., the pins 109 are shown as being uniform in size, but they can vary in size.

The body 101 can include two plates such that the pins 109 are disposed between the two plates, i.e., integral with one or both plates to facilitate heat transfer between the plates and the flow passing through the fluid channel 107. In some embodiments, the body 101 is a formed as single piece defining the channels 107 and the pins 109 disposed therein (e.g., via additive manufacturing). The body 101 can include aluminum or any other suitable thermally conductive material. The material or combination of materials that form the body 101 can be selected to account for thermal transfer properties to efficiently transfer heat to the fluid in the body 101.

As disclosed herein, the heat transfer device 100 efficiently transfers heat from a heat source by allowing a coolant (e.g., water or any other suitable refrigerant) to efficiently pass through the body 101 via the channels 107. The design of the channels 107 allows for a longer path within the body 101 and additional time and impingement locations for heat to transfer to the coolant compared to alternate configurations. Such compact designs allow for much more efficient cooling of small heat generating devices.

In another aspect of this disclosure, a method includes forming a heat transfer device 100 by forming a body 101 that defines a plurality of fluidly isolated channels 107 within the body, each channel 107 connecting to the a fluid inlet 103 and a fluid outlet 105. This can include forming the heat transfer device 101 by additive manufacturing. Any other suitable process for forming the device 100 can be used without departing from the scope of this disclosure.

The methods, devices, and systems of the present disclosure, as described above and shown in the drawings, provide for a heat transfer device with superior properties including increased heat transfer. While the apparatus and methods of the subject disclosure have been shown and described with reference to embodiments, those skilled in the art will readily appreciate that changes and/or modifications may be made thereto without departing from the scope of the subject disclosure.

## Claims

1. A heat transfer device, comprising:
a body (101) defining a fluid inlet (103) and a fluid outlet (105);
a fluid channel (107) defined within the body, the fluid channel connected in fluid communication between the fluid inlet and the fluid outlet; and
a plurality of pins (109) disposed within the fluid channel such that flow passing through the fluid channel passes around the plurality of pins to facilitate heat transfer to the fluid from the body.

2. The device of claim 1, wherein the body (101) includes two plates such that the pins (109) are disposed across the channel (107) between the two plates to facilitate heat transfer between the plates and the flow passing through the fluid channel.

3. The device of claim 1 or 2, wherein the body (101) is configured to mount to an electrical component.

4. The device of any preceding claim, wherein the body (101) is about 0.08 inches thick.

5. The device of any preceding claim, wherein the body (101) defines a plurality of fluid channels (107) connected in series.

6. The device of claim 5, wherein the body (101) defines an inlet-outlet plenum (112) fluidly connecting between sequential channels (107).

7. The device of any preceding claim, wherein the pins (109) are about 0.04 inches in diameter.

8. The device of any preceding claim, wherein the pins (109) are disposed in a predetermined pattern such that the pins are uniformly spaced within the fluid channel (107).

9. The device of any preceding claim, wherein the fluid channel (107) follows a sigmoid path.

10. The device of any preceding claim, wherein the plurality of pins (109) include at least one pin of a first diameter and at least one pin of a second diameter different from the first diameter.

11. The device of any preceding claim, wherein the body includes aluminum.

12. A method, comprising:
forming a heat transfer device by forming a body (101) defining a fluid channel (107) defined within the body, the fluid channel fluidly connecting between a fluid inlet (103) and a fluid outlet (105); and
forming a plurality of pins (109) disposed within the fluid channel such that flow passing through the fluid channel passes around the plurality of pins to facilitate heat transfer to the fluid from the body.

13. The method of claim 12, wherein forming includes forming the body (101) by additive manufacturing.
